# EUROPEAN PATENT APPLICATION

(11) **EP 4 575 716 A1**
(43) Date of publication of application: **25.06.2025**
(21) Application number: 23858791.9
(22) Date of filing: 07.06.2023
(51) Int. Cl.: G06F 1/18

(54) **SERVER AND ELECTRONIC DEVICE**

(30) Priority: 01.09.2022 CN 202211065813
(71) Applicant: xFusion Digital Technologies Co., Ltd., Zhengzhou, Henan 450046 (CN)
(72) Inventor: SU, Yimeng, Zhengzhou, Henan 450046 (CN); WANG, Yunfu, Zhengzhou, Henan 450046 (CN); XIAO, Sa, Zhengzhou, Henan 450046 (CN)
(74) Representative: MERH-IP Matias Erny Reichl Hoffmann Patentanwälte PartG mbB
(86) International application number: PCT/CN2023/099008
(87) International publication number: WO 2024/045752

(57) **Abstract**

Embodiments of this application relate to a server and an electronic device that pertain to the field of computer technology. The server and the device are used to resolve the problem that memory module groups inside a server are difficult to expand and therefore the processing performance of the server is limited. The server includes a mainboard, a CPU, and an expanded memory module group. The mainboard comprises memory expansion connectors. The CPU is on the mainboard and is coupled to the memory expansion connectors. The expanded memory module group is on one side of and spaced from the mainboard, and is coupled to memory expansion connectors.

## Description

This application claims priority to Chinese Patent Application No.202211065813.X, filed with the National Intellectual Property Administration on September 1, 2022, and entitled "SERVER AND ELECTRONIC DEVICE", which is incorporated herein by reference in its entirety.

### TECHNICAL FIELD

The present disclosure relates to the field of computer technology, and in particular, to servers and electronic devices.

### BACKGROUND

A server is a type of computer. It is a high-performance computer in a network that provides various services to client computers. Under the control of an operating system, a server shares access to connected external devices (such as drives and printers) with client sites on the network and offers centralized computing, information release, data management and other services to network users.

A server includes a mainboard, a memory module group, a central processing unit (Central processing unit, CPU), a power supply module, peripheral card modules (such as a network interface card module and a sound card module), a drive module, and other components. The performance of the memory module group has a significant impact on that of the server, as the memory module group is used to temporarily store operational data of the CPU, as well as at least one of the following: data exchanged between the CPU and the drive module, data exchanged between the CPU and an external storage device, and data exchanged between the CPU and the network. While the server is running, the CPU stores the data to be operated to the memory module group. The CPU reads the data from the memory module group for operation and writes the operation results to the memory module group. In this case, the capacity of the memory module group determines the processing performance of the server. Currently, due to the limited space to arrange a plurality of modules in a server, it is hard for memory module groups to expand, thereby limiting processing performance of a server.

### SUMMARY

Embodiments of the present application provide a server and an electronic device for improving the processing performance of a server by increasing a quantity of memory in the server.

To achieve the above objectives, the embodiments of the present application adopt the following technical solutions:

In a first aspect, a server is provided. The server includes a mainboard, a CPU, and an expanded memory module group. The mainboard includes memory expansion connectors. The CPU is located on the mainboard and coupled to the memory expansion connectors. The expanded memory module group is located at one side of the mainboard and is spaced from the mainboard; the expanded memory module group is coupled to the memory expansion connectors.

The server provided in the embodiments of the present disclosure, by arranging the expanded memory module group on one side of the mainboard and spaced from the mainboard, ensures that the expanded memory module group is not confined by the space on the surface of the mainboard. Based on the memory module group on the mainboard, the greater quantity of memory that communicates with the CPU is arranged, improving the running performance of the server.

In addition, the space on one side of the mainboard in a server is larger than the space on the mainboard. Even if there is no memory module group on the mainboard, more expanded memory module groups may be arranged by one side of the mainboard. This allows for the greater quantity of memory that communicates with the CPU, improving the running performance of the server.

In some embodiments, the expanded memory module group includes a plurality of expanded memory units. The plurality of expanded memory units are independently arranged, and each expanded memory unit is coupled to one or more memory expansion connectors.

To arrange the plurality of expanded memory units independently may refer to the fact that the plurality of expanded memory units are not coupled to each other via electrical cables, avoiding direct signal interaction between the expanded memory units. The plurality of independent expanded memory units perform the memory functionality independently without mutual interference. In a case that one expanded memory unit fails, the normal operation of other expanded memory units is not affected so that the reliability of expanded memory module groups is improved.

In some embodiments, each expanded memory unit includes a circuit board. A plurality of circuit boards of different expanded memory units are spaced from each other.

Understandably, the expanded memory module group includes a plurality of circuit boards spaced from each other. Each expanded memory unit includes a circuit board and functional components disposed on the circuit board to perform the memory functionality. The plurality of expanded memory units are spaced from each other, which can be understood as that circuit boards of different expanded memory units are not shared.

Due to varying sizes of different functional modules in a direction perpendicular to the mainboard in the server, the size of the space on one side of the mainboard in the direction perpendicular to the mainboard in the server is more complex, making it difficult to accommodate an expanded memory module group with a large overall capacity. In this embodiment, the expanded memory module group includes a plurality of expanded memory units with independent circuit boards, enabling flexible arrangement of the expanded memory units on one side of the mainboard in the server. Thus, the number of expanded memory units that can be arranged in a server is increased, the quantity of memory that communicates with the CPU increases, and the running performance of the server is improved.

In some embodiments, each expanded memory unit includes a circuit board. A plurality of circuit boards of different expanded memory units are connected to form an integrated structure.

Each expanded memory unit includes a circuit board and functional components disposed on the circuit board to perform the memory functionality. In this embodiment, a plurality of circuit boards of different expanded memory units are close to each other, forming an integrated circuit board.

Alternatively, it can be understood that the plurality of expanded memory units share a single circuit board, where different expanded memory units occupy different regions of the circuit board, enabling different regions to independently perform the memory functionality. With the plurality of expanded memory units sharing a single circuit board, the plurality of expanded memory units are arranged in a centralized manner within a server, facilitating easier maintenance and replacement of the expanded memory module group.

In some embodiments, the server includes a first cable that supports a cache-coherent bus. The expanded memory unit includes a first high-speed connector and memory media. The first high-speed connector is coupled to the memory expansion connectors via the first cable. The memory media are coupled to the first high-speed connectors.

The first high-speed connector, by means of the cache-coherence bus, is coupled to the CPU via the memory expansion connectors in order to leverage a channel other than a channel configured in communication with the memory module group in the CPU. This increases the quantity of memory that communicates with the CPU by adding a communication channel between the CPU and memory module group.

In some embodiments, the expanded memory unit also includes a memory expansion controller. The memory expansion controller is arranged between a first high-speed connector and the memory media. A plurality of memory media coupled to a memory expansion controller may be one or more types.

Since the memory expansion controller is serially connected between the first high-speed connector and the memory media, the performance of CPU is not restricted by the types of storage media in the expanded memory module group. The types of a plurality of memory media coupled to a same memory expansion controller may be different, increasing the diversity of memory media in the server.

In some embodiments, the mainboard also includes a second high-speed connector. At least one communication protocol supported by the second high-speed connector is a communication protocol supported by the first high-speed connector. The second high-speed connector is multiplexed as a memory expansion connector.

The second high-speed connector is a connector originally installed on the mainboard, and may support one or more communication protocols. In a case where the second high-speed connector supports a plurality of communication protocols, the second high-speed connector may perform different functions by switching a communication protocol used by the second high-speed connector. In this case, at least one communication protocol supported by the second high-speed connector is the communication protocol supported by the first high-speed connector. By switching the communication protocol of the second high-speed connector to the communication protocol supported by the first high-speed connector, signal interactions between the first high-speed connector and the second high-speed connector are achieved.

In this way, additional modifications to the circuit of the mainboard and the cost of adding a dedicated memory expansion connector may be avoided, and the compatibility of the server may be optimized.

In some embodiments, the server also includes a baseboard management controller (BMC) and a second cable that supports the system management bus (SMBus). The BMC is coupled to a first high-speed connector via a second cable.

The BMC, the second cable that supports the SMBus, and an out-of-band port of the first high-speed connector together constitute a dedicated management network that is independent from a data network (the data network includes a communication channel between a CPU and a data port of the first high-speed connector), which achieves out-of-band management of the expanded memory module group. The out-of-band management includes, but is not limited to intelligent power distribution, load measurement, temperature monitoring, error detection, log querying, device management and remote control.

In some embodiments, at least one of the first cable or the second cable is a flexible cable.

If the first cable is a flexible cable, the first cable can bypass other structures between the memory expansion connectors and the expanded memory module group within the server, which facilitates to achieve coupling between the first high-speed connector and the memory expansion connector, and also to be more adaptable to a positional change of the expanded memory module group relative to the mainboard.

If the second cable is a flexible cable, the second cable can bypass other structures between the BMC and the expanded memory module group within the server, which facilitates to achieve coupling between the first high-speed connector and the BMC, and also to be more adaptive to a positional change of the expanded memory module group relative to the mainboard.

In some embodiments, the first cable and the second cable can be a same cable. Understandably, the first cable and the second cable are integrated into a single physical cable.

In some embodiments, the length of a flexible cable is less than or equal to 150 cm.

This allows for easier arrangement of the flexible cable and increases flexibility of the flexible cable in the arrangement of the server.

In some embodiments, the server includes a power supply cable, the expanded memory unit further includes a first power connector, and the mainboard includes a second power connector. The second power connector is coupled to the first power connector via a power supply cable. The first power connector and/or the second power connector includes at least one of a 2 x 3-pin power connector, 2 x 4-pin power connector or 2 x 6-pin power connector.

The power connectors may be at least one of the following types compliant with the PCIE CEM standard: 2 x 3-pin power connectors, 2 x 4-pin power connectors or 2 x 6-pin power connectors. The first power connector and the second power connector may be of a same type. For example, both of the first power connector and the second power connector are 2 x 3-pin power connectors, or 2 x 4-pin power connectors. The first power connector and the second power connector may also be of different types. For example, the first power connector is a 2 x 3-pin power connector, and the second power connector is a 2 x 6-pin power connector. One 2 x 6-pin power connector is coupled to two 2 x 3-pin power connectors.

In this case, the server may select, based on actual conditions, appropriate power supply cables and power connectors when there are a plurality of patterns of power supply cables and power connectors available, enhancing the flexibility of server assembly.

In some embodiments, the server also includes a housing and a bracket. The housing encloses an accommodation cavity, and a mainboard is located in the accommodation cavity. The bracket is connected to the housing; the bracket is located on one side of the mainboard and spaced from the mainboard, and the expanded memory module group is mounted on the bracket.

The bracket may be fixedly connected to a bottom cover of the housing. For example, the bracket is fixedly connected to the bottom cover by a screw, and constructs, on one side of the mainboard, a floating platform with a supporting capacity that is spaced relative to the mainboard. The expanded memory module group is fixed connected to the floating platform, thereby arranging the expanded memory module group on one side of the mainboard and spaced from the mainboard.

The bracket may also be fixedly connected to two oppositely arranged enclosure frames of the housing. For example, the bracket includes two connecting parts and a suspension part located between the two connecting parts. The two connecting parts are screwed to the two oppositely arranged enclosure frames of the housing respectively, and the suspension part is connected to the expanded memory module group, so as to arrange the expanded memory module group on one side of the mainboard and spaced from the mainboard.

The bracket and the housing cooperate to arrange the expanded memory module group on one side of the mainboard and spaced from the mainboard, without affecting other functional modules on the mainboard.

In some embodiments, the expanded memory module group and the CPU are on a same side of the mainboard. An orthographic projection of the expanded memory module group at least partially overlaps that of the CPU on the mainboard.

The orthographic projection of the expanded module on the mainboard at least partially overlaps with the orthographic projection of the CPU on the mainboard. The expanded memory module group is arranged close to the CPU to reduce a transmission distance during signal interactions between the expanded memory module group and the CPU and to ensure integrity of signal transmission. Meanwhile, there are no obstructions on one side of the CPU away from the mainboard in the server, facilitating installation of the expanded memory module group.

In some embodiments, the server also includes a memory module group. The memory module group is on the mainboard and spaced from the CPU. An orthographic projection of the expanded memory module group on the mainboard at least partially overlaps with an orthographic projection of the memory module group on the mainboard.

The memory module group and the expanded memory module group may be arranged on a same side of the mainboard and coupled to the CPU. The orthographic projection of the expanded memory module group on the mainboard at least partially overlaps with the orthographic projection of the memory module group on the mainboard, allowing for the concentrated arrangement of the memory that communicates with the CPU, facilitating maintenance and replacement of the memory module group in the server. Additionally, there are no obstructions on a side of the memory module groups away from the mainboard in the server, facilitating the installation of the expanded memory module group.

In some embodiments, the memory expansion connector and the expanded memory module group are on a same side of the mainboard. The orthographic projection of the memory expansion connector on the mainboard does not overlap with the orthographic projection of the expanded memory module group on the mainboard.

The orthographic projection of the memory expansion connector on the mainboard does not overlap with the orthographic projection of the expanded memory module group on the mainboard. Understandably, the expanded memory module group avoids covering the memory expansion connector on the mainboard. After the expanded memory module group is installed, the assembly of a cable and the memory expansion connector become more convenient.

In some embodiments, the server also includes an input/output module and a heat dissipation module. The input/output module is coupled to the mainboard, and the heat dissipation module is coupled to the mainboard. The expanded memory module group is arranged between the input/output module and the heat dissipation module.

There are different ports on the input/output module, resulting in a large size of the input/output module in the direction perpendicular to the mainboard. Similarly, the heat dissipation module may be a fan module. A fan with a large volume results in a larger size of the heat dissipation module in the direction perpendicular to the mainboard.

In the embodiment, the expanded memory module group is arranged between an input/output module and a heat dissipation module to bypass the input/output module and the heat dissipation module and reduce a size of the server in the direction perpendicular to the mainboard, leading to a smaller server size.

In some embodiments, in the direction perpendicular to the mainboard, there is at least partial overlap between a height range of the input/output module and a height range of an expanded memory module group.

Understandably, the height range of the input/output module in the direction perpendicular to the mainboard overlaps with the height range of the expanded memory module group in the same direction. This optimizes the internal spatial arrangement of the server, making the height of the server perpendicular to the mainboard less than a sum of the heights of the input/output module and the expanded memory module group perpendicular to the mainboard. This way leads to a smaller server size.

In some embodiments, in the direction perpendicular to the mainboard, there is at least partial overlap between the height range of a heat dissipation module and the height range of an expanded memory module group.

Understandably, the height range of the heat dissipation module perpendicular to the mainboard overlaps with the height range of the expanded memory module group perpendicular to the mainboard. This optimizes the internal spatial arrangement of the server, making a size of the server perpendicular to the mainboard less than a sum of the heights of the input/output module and the expanded memory module group perpendicular to the mainboard. This way leads to a smaller server size.

In a second aspect, an electronic device is provided. The electronic device includes a power supply and a server. The server is coupled to the power supply, and the server is a server of any of the embodiments as described above.

The technical effect of the second aspect can refer to that of the first aspect, and details are not described herein again.

### BRIEF DESCRIPTION OF DRAWINGS

FIG. 1 is a schematic diagram illustrating the arrangement of the CPU and memory module groups on a mainboard according to some embodiments;
FIG. 2 is a schematic diagram of a three-dimensional structure of a server according to some embodiments;
FIG. 3 is a top view of a mainboard in a server according to some embodiments;
FIG. 4 is a sectional view taken along the line A-A' in FIG. 3;
FIG. 5 is a top view of a mainboard in a server according to some embodiments;
FIG. 6 is a schematic diagram illustrating the arrangement of the CPU, memory module groups, and expanded memory module groups in a server according to some embodiments;
FIG. 7 is a schematic diagram of a structure of expanded memory module groups in a server according to some embodiments;
FIG. 8 is a schematic diagram of a structure of a server according to some embodiments;
FIG. 9 is a schematic diagram of a structure of a server according to some embodiments.

### DESCRIPTION OF EMBODIMENTS

The following describes technical solutions in embodiments of the present application with reference to accompanying drawings in the embodiments of the present application. It is obvious that the described embodiments are only a part of the embodiments of the present application, and not all of the embodiments.

The technical solutions in the embodiments of the present application are clearly and completely described in the following with reference to the drawings in the embodiments of the present application. It is obvious that the described embodiments are only a part of the embodiments of the present application, and not all of the embodiments. All other embodiments obtained by a person of ordinary skill in the art based on the embodiments of the present application shall fall within the protection scope of the present application.

Hereinafter, the terms "first" and "second" are used for descriptive purposes only, and shall not be construed as indicating or implying relative importance or implicitly indicating the quantity of technical features indicated. Therefore, the features defined by "first" and "second" may explicitly or implicitly include one or more of the features. In the description of the embodiments of the present application, the term "a plurality of" means two or more unless otherwise specified.

In the description of some embodiments, the terms "connection", "connect", and their extensions may be used. For example, the term "connection" may be used in some embodiments to indicate that two or more components may be in direct or indirect physical contact with each other. For example, the connection between A and B may indicate a direct connection between A and B, or it may indicate a connection between A and B through other components. In addition, the term "coupled" may refer to an electrical connection that facilitates signal transmission.

"At least one of A, B, and C" has the same meaning as "at least one of A, B, or C", and both include the following combinations of A, B, and C: A only, B only, C only, a combination of A and B, a combination of A and C, a combination of B and C, and a combination of A, B, and C.

The phrase 'A and/or B' includes the following three combinations: A only, B only, and the combination of A and B.

As used throughout this specification, the terms "about", "substantially", or "approximately" include a stated value and an average within an acceptable range of deviation of a particular value. The acceptable range of deviation is determined by a person of ordinary skill in the art in view of the measurement in question and the error associated with the measurement of a particular quantity (i.e., the limitations of the measurement system).

As used throughout this specification, "parallel", "perpendicular", and "equal" include not only the stated condition and its similar conditions within an acceptable range of deviation. The acceptable range of deviation is determined by a person of ordinary skill in the art in view of the measurement in question and the error associated with the measurement of a particular quantity (i.e., the limitations of the measurement system). For example, "parallel" includes absolute parallel and approximately parallel, where the acceptable deviation range of approximately parallel may be, for example, within 5°. "Perpendicular" includes absolutely perpendicular and approximately perpendicular, where the acceptable deviation range of approximate perpendicular may also be, for example, within 5°. "Equal" includes both absolutely equal and approximately equal, where the difference between the two within the acceptable deviation range of approximately equal, for example, which may be equal, is less than or equal to 5% of either one.

The embodiment of the present application provides a server. This type of server may act as server devices of a network service provider or a content provider.

Based on the form factor, the server may be a rack server, a blade server, or a tower server, which is not limited herein. For the sake of subsequent explanation, this document uses a rack server as an example.

The rack server can be installed in a cabinet. Rack servers may be in various sizes, such as 1U standard rack servers, 2U standard rack servers, 3U standard rack servers, 4U standard rack servers, 5U standard rack servers, 6U standard rack servers, 8U standard rack servers, and so on. A rack has mounting spaces for different sizes and screw holes for securing the rack servers. The screw holes on the rack align with screw holes on the servers, and screws are inserted through the aligned holes on both the rack and the servers for secure fastening of the rack servers, so an installation position for each rack server is defined.

The server provided in the embodiment of the present application may include a housing, a mainboard within the housing, and a plurality of functional modules. The functional modules may include a CPU, a heat dissipation module, an input/output (I/O) module, a PSU, a memory module group, a drive module, and so on. Each functional module is electrically connected to a mainboard or cable to achieve functions, thereby enabling the server to function as an integrated system. The performance of the memory module group has a significant impact on the server, and the memory module group is used to temporarily store operational data of the CPU and at least one of data exchanged between the CPU and the drive module, data exchanged between the CPU and external storage, or data exchanged between the CPU and the network. While the server is running, the CPU transfers data to be processed to the memory module group for storage. The CPU reads data from the memory module group for operation and then writes an operation result to the memory module group. Therefore, the capacity of the memory module group determines the processing performance of the server.

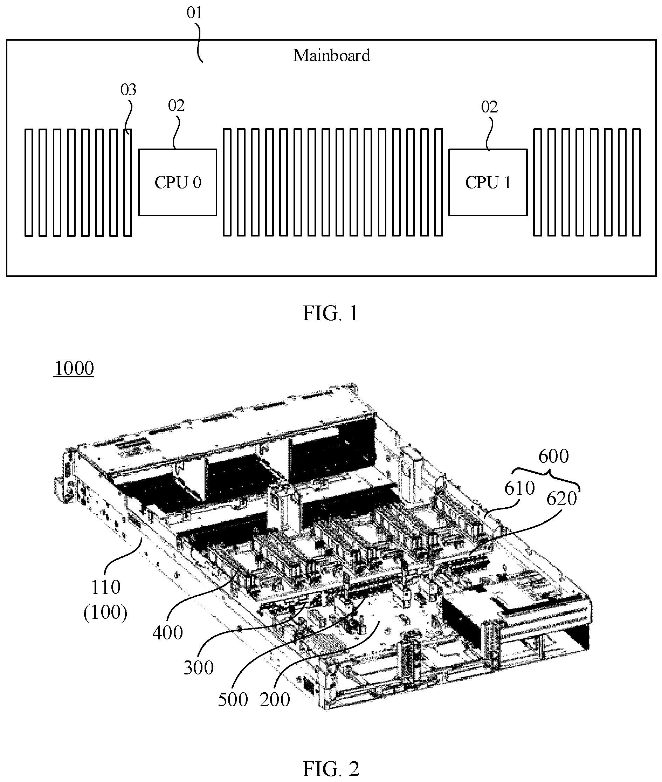

Currently, servers on the market have standardized sizes, limiting the layout areas of a plurality of modules within the server. Therefore, the memory module group is difficult to be expanded, which restricts the operating capacity of the server. FIG. 1 is a structural diagram of CPUs and memory slots on a mainboard in some embodiments. As shown in the example of FIG. 1, a server can be a 2U standard rack server, where on a mainboard 01, two CPUs (CPU 0 and CPU 1) 02 are arranged in alignment. Based on the feasibility assessment of the mainboard 01, each CPU 02 is provided with eight physical channels, with each physical channel supporting two memory slots 03. Therefore, the mainboard 01 supports up to 32 memory slots 03, making it difficult to further expand the memory of the server.

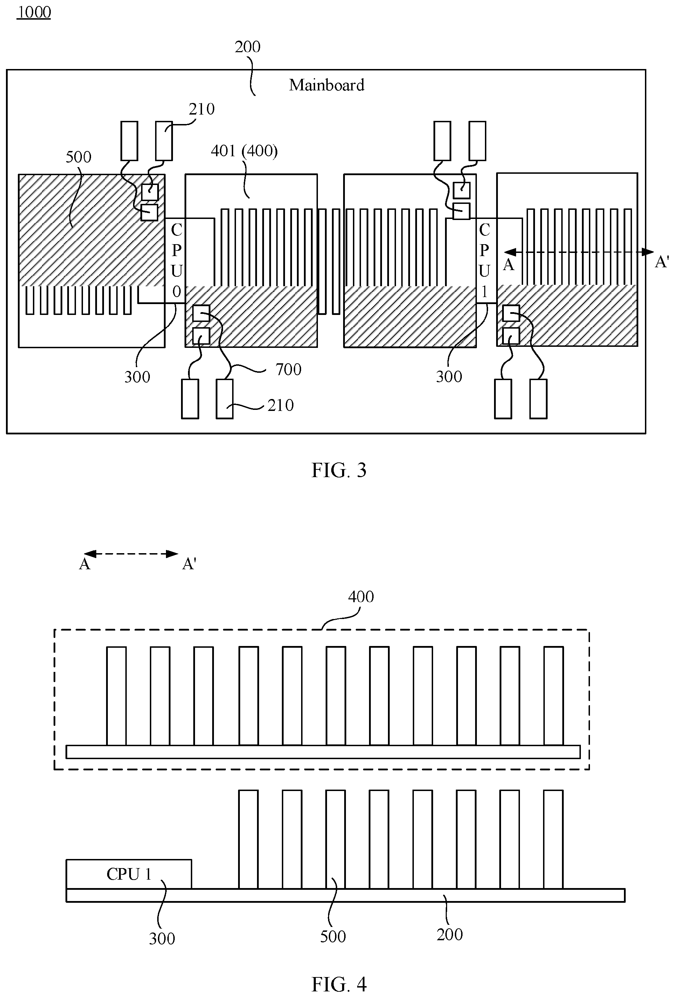

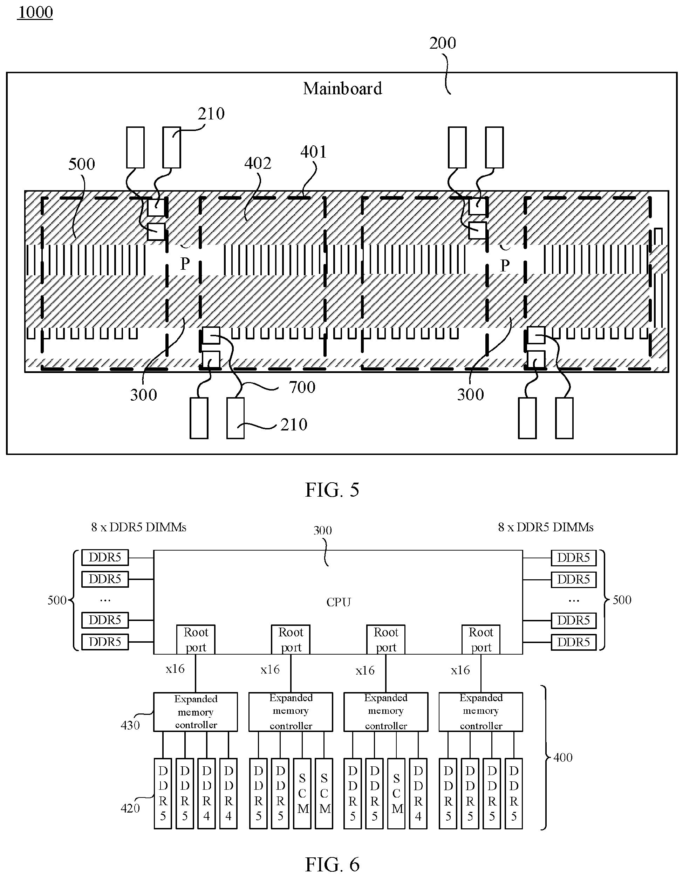

FIG. 2 is a three-dimensional structural diagram of some functional modules in a server in some embodiments. FIG. 3 is a top view of a mainboard in a server based on some embodiments; FIG. 4 is a cross-sectional view along line A-A' in FIG. 3. FIG. 5 is a top view of a mainboard in the server based on some embodiments. As shown in FIG. 2 to FIG. 5, the server 1000 in the embodiment includes a housing 100, and a mainboard 200, a CPU 300, and an expanded memory module group 400 which are located in the housing 100.

The housing 100 may be plastic or metal. The interior of the housing 100 has an accommodation space for the mainboard 200, the CPU 300, the expanded memory module group 400, and other functional modules. The housing 100 defines the installation positions of various functional modules in the server 1000, while protecting the functional modules within the accommodation space from external damage.

In some examples, the server 1000 and the housing 100 are rectangular. The housing 100 may include a bottom cover and a top cover that are opposite to each other, and enclosure frames 110 which are respectively connected to the bottom cover and the top cover. The bottom cover, the top cover, and the enclosure frames 110 may enclose a closed or open accommodation space. In addition, the housing 100 may have a plurality of positioning holes, which secure the functional modules and define the accommodation space in the housing 100.

The mainboard 200 is one of the most core components of the server 1000. The mainboard 200 may be provided with a positioning hole. Through the positioning hole in the mainboard and the positioning hole in the bottom cover of the housing, the mainboard 200 is secured to the bottom cover.

The mainboard 200 may be provided with a variety of slots, and is internally equipped with electrical cables connected to the slots. After the functional modules are inserted into the slots, a plurality of functional modules in the slots within the mainboard 200 may be coupled to each other, enabling signal interaction among the functional modules.

For example, the mainboard 200 is equipped with a CPU socket and a memory slot. Pins of the CPU 300 are inserted into the CPU socket on the mainboard 200 and pins of the memory module group are inserted into the memory slot on the mainboard 200. The CPU 300 and the memory module group may be spaced apart and coupled via the electrical cables of the mainboard 200, enabling signal interaction between the CPU 300 and the memory module group. In other embodiments, the mainboard 200 may not have a CPU socket, and the CPU 300 is directly mounted on the surface of the mainboard 200.

In some examples, the mainboard 200 may also have other slots, such as southbridge chip slots, graphics processing unit (Graphics Processing Unit, GPU) slots, drive slots, integrated sound card slots, integrated NIC slots, and so on. The CPU 300 may also exchange signals with functional modules such as a southbridge chip, a GPU, a drive module, an integrated sound card, and an integrated NIC by the mainboard 200.

In some other examples, the mainboard 200 may also be integrated with expansion slots such as Peripheral Component Interconnect Express (Peripheral Component Interconnect Express, PCIE) slots. PCIE supports a point-to-point, dual-channel, and high-bandwidth peripheral connection. Devices connected over PCIE are allocated a dedicated channel bandwidth, and do not share a bus bandwidth. PCIE features a high data transfer rate, which improves the signal interaction efficiency between two functional modules connected by PCIE, thereby increasing the efficiency of data interaction within the server.

The CPU 300 is the computing core of the server 1000. The CPU 300 may include at least an arithmetic logic unit, a register, and a control unit. The arithmetic logic unit primarily performs logical calculations, such as shift and logical operations, fixed-point or floating-point arithmetic operations, and execution of commands for address calculation and conversion. The arithmetic logic unit is a multi-functional arithmetic unit. The register can be used as a storage cell to temporarily hold instructions, data, and addresses. The control unit can be used to analyze commands and issue control signals.

The expanded memory module group 400 is coupled to the CPU 300, and provides a same function as a common memory module group. Therefore, the expanded memory module group 400 may temporarily store operational data of the CPU 300, and at least one of data exchanged between the CPU and the drive module, data exchanged between the CPU and external storage, or data exchanged between the CPU and the network. When the server is running, the CPU 300 may transfer data that needs to be processed to the expanded memory module group 400 for storage, read data from the expanded memory module group 400 for processing, and then write a processing consequence back to the expanded memory module group 400.

As shown in FIG. 4, the expanded memory module group 400 is installed on one side of and spaced from the mainboard 200. The expanded memory module group 400 may be on a same side of the mainboard 200 as the CPU 300. It can be understood that the expanded memory module group 400 is located in the space above the mainboard 200 but does not touch the mainboard 200. In the example, an upper space where the memory module group 400 is located may cover an area on the mainboard 200 where the functional modules have been installed, an area on the mainboard 200 where no functional module is installed, or an area beyond the mainboard 200. Therefore, a space on one side of the mainboard 200 is greater than a space available for expansion on the mainboard 200.

In this way, the installation of the expansion memory module group 400 is not constrained by the surface area of the mainboard 200, allowing for the greater quantity of memory for signal interaction with the CPU 300.

In some examples, the server includes an expanded memory module group 400 on one side of the mainboard 200, but does not include the memory module group installed on the mainboard 200. Therefore, on the mainboard 200, a space originally reserved for the memory module group may be used to expand other functional modules, facilitating the expansion of other functional modules on the mainboard. For example, additional CPUs 300 may be added in the space originally reserved for the memory module group to enhance the operational capability.

In some other examples, as shown in FIG. 3, the server may include an expanded memory module group 400 on one side of the mainboard 200 and a memory module group 500 installed on the mainboard 200. The memory module group 500 and the expanded memory module group 400 are arranged in layers. The CPU 300 may transfer data that needs to be processed to the expanded memory module group 400 for storage, read data from the expanded memory module group 400 for processing, and then write a processing consequence back to the expanded memory module group 400. The CPU 300 may also transfer another part of the data that needs to be processed to the memory module group 500 for storage, read data from the memory module group 500 for processing, and then write a processing consequence back to the memory module group 500. This allows more memory units to cooperate with the CPU 300, thereby improving the processing performance of the server.

In addition, the expanded memory module group is configured on one side of the mainboard, which effectively utilizes a remaining space inside the server, allowing more memory units to cooperate with the CPU 300 and enhancing the memory density of the server without increasing the overall size of the server.

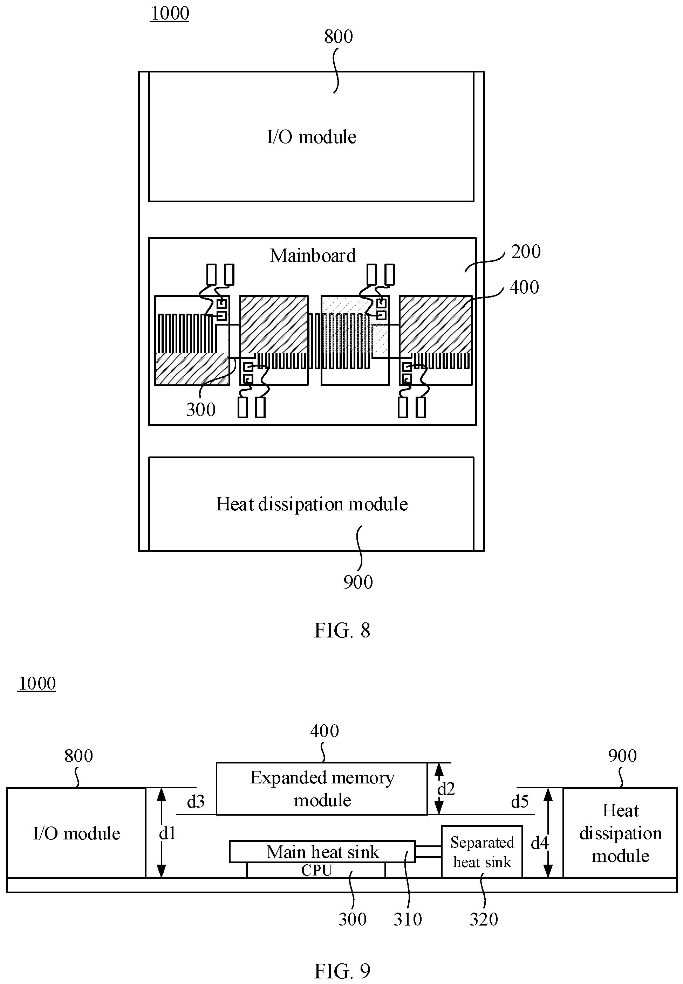

As shown in FIG. 9, in some embodiments, the server may also include heat sinks. The heat sinks may include a main heat sink 310 and a split heat sink 320. The main heat sink 310 is arranged around the CPU 300 to dissipate heat for the CPU 300. The split heat sink 320 is connected to the main heat sink 310 by a heat pipe to enhance the cooling capacity for the CPU 300. A quantity of the split heat sinks 320 may be one or more, which is not limited here.

In some examples, when the server does not include the expanded memory module group 400, the main heat sink 310 is located on one side of the CPU 300 away from the mainboard 200 and has a greater dimension in the direction perpendicular to the mainboard 200, to meet the cooling requirements of the CPU. When the server includes the memory module group 400, the main heat sink 310 may be made thinner in the direction perpendicular to the mainboard 200. A split heat sink 320 connected to the main heat sink 310 may be added to maintain the cooling performance at approximately the same level to meet the cooling requirements of the CPU.

The main heat sink 310 may be made thinner in the direction perpendicular to the mainboard 200 in other ways as well, which is an example for illustration and is not considered as a limitation to the solution.

In some other examples, an orthogonal projection of the expanded memory module group 400 on the mainboard may not overlap with that of the CPU 300 on the mainboard. Understandably, the expanded memory module group 400 is not placed directly above the CPU 300, thus preventing modifying the main heat sink and facilitating expansion of the expanded memory module group 400 in the server.

As shown in FIG. 2 and FIG. 3, in some embodiments, the mainboard 200 may also include a memory expansion connector 210. The memory expansion connector 210 is coupled to the expanded memory module group 400, and is coupled to the CPU 300. Thus, the expanded memory module group 400 is coupled to the CPU 300, allowing for coordination between the expansion memory module group 400 and the CPU 300 to achieve data processing and storage.

The expanded memory module group 400 may include one or more expanded memory units. In some examples, the expanded memory units may be independently arranged on one side of the mainboard 200. Independent arrangement of the expanded memory units means that the expanded memory units are not coupled, resulting in no direct signal interaction among the expanded memory units. The plurality of independently arranged memory units can function independently without affecting each other. A failure in one expanded memory unit does not affect other expended memory units, thus improving the reliability of the expanded memory module group.

As shown in FIG. 3, in some embodiments, each expanded memory unit 401 includes a circuit board. A plurality of circuit boards of different expanded memory units 401 are spaced apart from each other.

Understandably, the expanded memory module group includes a plurality of circuit boards that are independent and spaced apart from each other. Each expanded memory unit includes a circuit board and functional devices on the circuit board to achieve the function of the memory. The plurality of expanded memory units are spaced apart, which indicates that the circuit boards of different expanded memory units are not shared.

Due to varying dimensions of different functional modules in the direction perpendicular to the mainboard in the server, the space arrangement on one side of the mainboard is complex, which is difficult to accommodate a larger expanded memory module group. In the embodiment, the expanded memory module group includes a plurality of expanded memory units with independent circuit boards, which enhances the layout flexibility for the expanded memory units on one side of the mainboard in the server. This allows more expanded memory units in the server, thus enabling more units to cooperate with the CPU and improving the operating performance of the server.

As shown in FIG. 5, in some embodiments, each expanded memory unit 401 includes a circuit board 402, and a plurality of circuit boards 402 of different expanded memory units 401 are interconnected to form an integral structure.

Each expanded memory unit 401 includes a circuit board 402 and functional devices on the circuit board to achieve the function of the memory. In the embodiment, a plurality of circuit boards 402 of different expanded memory units 401 are close to each other, combining to form a circuit board.

In other words, a plurality of expanded memory module groups 401 share a circuit board, where different expanded memory module groups occupy different areas of the circuit board. This allows different areas of the circuit board to independently perform the memory functionality. Sharing the same circuit board among a plurality of expanded memory units allows a centralized arrangement of the plurality of expanded memory units within the server, facilitating maintenance and replacement of the expanded memory module group.

A quantity of the memory expansion connectors 210 may be equal to a quantity of the expanded memory units. For example, a plurality of expanded memory units are coupled to a plurality of memory expansion connectors 210 in a one-to-one correspondence. The quantity of the memory expansion connectors 210 may also be unequal to the quantity of expanded memory units. For example, one expanded memory unit may be coupled to a plurality of memory expansion connectors 210, or a plurality of expanded memory units may be coupled to one memory expansion connector 210.

In some examples, the memory expansion connector 210 may be additionally provided on the basis of the original mainboard 200 for coupling with the expanded memory module group 400. In other words, the memory expansion connector 210 exist only when the server includes the expanded memory module group 400. Additionally, the mainboard 200 is equipped with a circuit cable that couples the memory expansion connector 210 to the CPU 300. This allows signal interaction between the CPU 300 and the expanded memory module group 400 without occupying existing connectors on the mainboard 200, thereby achieving data processing and storage.

In some other examples, the expanded memory module group may include a first high-speed connector installed on the circuit board. The memory expansion connector 210 may also be a second high-speed connector originally provided on the mainboard 200. The second high-speed connector originally on the mainboard 200 is compatible with the expanded memory module group 400, which means the second high-speed connector supports at least one communication protocol, including a communication protocol supported by the first high-speed connector. For example, the second high-speed connector supports a plurality of communication protocols: Peripheral Component Interconnect Express (PCIE) and Compute Express Link (Compute Express Link, CXL), where CXL is supported by the first high-speed connector.

The second high-speed connector and the CPU 300 may be coupled by a plurality of communication protocols (such as PCIE and CXL), and the CPU 300 may automatically negotiate a communication protocol with the expanded memory module group 400 by the second high-speed connector. This enables the CPU, the second high-speed connector, and the first high-speed connector to support the same communication protocol (such as CXL). In this way, the second high-speed connector serves as the memory expansion connectors 210. The original circuit cables on the mainboard 200 that are respectively coupled to the memory expansion connectors 210 and the CPU 300, the CPU 300 and the expanded memory module group 400 may exchange signals and coordinate on operations.

In some embodiments, the memory expansion connector 210 is coupled to the expanded memory module group 400 by a flexible cable bundle 700. The flexible cable bundle 700 may include interfaces at two ends coupled to the memory expansion connector 210 and the expanded memory module group 400, and a flexible connection cable bundle that connects the interfaces at two ends.

For example, the flexible cable bundle 700 may include high-speed cables and connectors that support the PCIE standard, such as Mini Cool Edge Input/Output (Mini Cool Edge input/output, MCIO) cables and connectors, slimline (Slimline) cables and connectors, Union Bus Connector (Union Bus Connector, UBC) cables and connectors, Union Bus Connector Double Density (Union Bus Connector Double Density UBCDD) cables and connectors, Slim Serial Attached Small Computer System Interface (Slim Serial Attached Small Computer System Interface, SlimSAS) cables and connectors, Mini Serial Attached Small Computer System Interface High Density (Mini Serial Attached Small Computer System Interface High Density, MiniSAS HD) cables and connectors, and other suitable cables and connectors, which is not limited herein.

In some examples, connectors at two ends of the flexible cable bundle 700 are same. For example, the flexible cable bundle 700 is connected to the expanded memory module group 400 and the memory expansion connector 210 by two MCIO connectors. In some other examples, the connectors at one end and at the other end of the flexible cable bundle 700 are different. For example, the flexible cable bundle 700 is connected to the expanded memory module group 400 by an MCIO connector and to the memory expansion connectors 210 by a UBC connector.

In some examples, quantities of connectors at two ends of the flexible cable bundle 700 are equal. For example, on the flexible cable bundle 700, quantities of connectors connected to the expanded memory module group 400 and to the memory expansion connectors 210 are both one. In some other examples, the quantities of the connectors at two ends of the flexible cable bundle 700 are unequal. For example, on the flexible cable bundle 700, there is one connector connected to the expanded memory module group 400, while there are a plurality of connectors connected to a plurality of memory expansion connectors 210.

In some embodiments, an extended length of the flexible cable bundle 700 may be less than or equal to 150 cm (59.06 in.), for example, 150 cm (59.06 in.), 140 cm (55.12 in.), 130 cm (51.18 in.), 120 cm (47.24 in.), 110 cm (43.314 in.), 100 cm (39.37 in.), 98 cm (38.58 in.), 95 cm (37.40 in.), 90 cm (35.43 in.), 85 cm (33.46 in.), 80 cm (31.50 in.), 75 cm (29.53 in.), 60 cm (23.62 in.), 50 cm (19.69 in.), 40 cm (15.75 in.), 30 cm (11.81 in.), 20 cm (7.87 in.), or 10 cm (3.94 in.). The flexible cable bundle 700 can be flexibly routed inside the server, coupling the memory expansion connector 210 and the expanded memory module group 400 without affecting the layout of the original modules.

The flexible cable bundle 700 supports data transfer. Restricting the flexible cable bundle 700 within 150 cm (59.06 in.) shortens a distance over which data is transferred, improving completeness of signals transmitted via the flexible cable bundle 700.

In some embodiments, the expanded memory unit in the expanded memory module group 400 may include a circuit board. When a plurality of expanded memory units may be independently arranged, circuit boards of the plurality of expanded memory units are independently arranged. When the plurality of expanded memory units are centrally arranged, the circuit boards of the plurality of expanded memory units may share a same circuit board.

The expanded memory unit may also include the first high-speed connector 410 and a memory medium, also known as a dual in-line memory module (DIMM), 420 installed on the circuit board. In this case, the memory medium can be installed with its pins inserted into a memory slot on the circuit board, or a memory medium chip (memory granule) may be directly soldered onto the circuit board.

The first high-speed connector 410 may support the PCIE standard. For example, the first high-speed connector 410 may be an MCIO connector, a Slimline connector, a UBC connector, a UBCDD connector, a SlimSAS connector, a MiniSAS HD connector, and so on.

The first high-speed connector 410 may support suitable communication protocols such as CXL, Open Coherent Accelerator Processor Interface (OpenCAPI), Generation Z (Generation Z, GenZ), high-speed GPU interconnect (NVLINK), and Cache Coherent Interconnect for Accelerators (CCIX), which is not limited herein.

The memory medium 420 may be storage class memory (Storage Class Memory, SCM), persistent memory (Persistent Memory, PMEM), or a dual in-line memory module (Dual-Inline-Memory-Modules, DIMM) such as DDR5 and DDR4.

The first high-speed connector 410 that supports the CXL communication protocol is taken as an example, where the flexible cable bundle 700 may include a first cable that supports the cache-coherent bus CXL. For example, the first high-speed connector 410 and the flexible cable bundle 700 support CXL 2.0, and their transmission rate reaches 32 GT/s; or the first high-speed connector 410 and the flexible cable bundle 700 support CXL 3.0, and their transmission rate reaches 64 GT/s. The first high-speed connector 410 is coupled to the memory expansion connectors 210 on the mainboard 200 via the first cable in the flexible cable bundle 700.

The first high-speed connector 410, coupled to the CPU 300 by the cache-coherent bus and the memory expansion connectors 210, can utilize channels other than those configured in the CPU 300 for communication with the memory module group 500. This increases the quantity of communication channels between the CPU 300 and the memory, thereby improving a bandwidth between the CPU 300 and the memory and facilitating the increase in the quantity of memory communicating with the CPU 300.

In some embodiments, one first high-speed connector 410 in the expanded memory unit is coupled to at least one memory medium 420. For example, the one first high-speed connector 410 is coupled to one memory medium 420, or the one first high-speed connector 410 is coupled to two memory media 420, or the one first high-speed connector 410 is coupled to four memory media 420.

It should be noted that the first high-speed connector 410 may be coupled to the memory medium 420 directly or indirectly, which is not limited herein.

In some embodiments, the first high-speed connector 410 may support at least one of an x16 port mode, x8 port mode, x4 port mode, x2 port mode, or x1 port mode. For example, connectors at two ends of the first cable are in the x8 port mode, the first high-speed connector 410 may be in the x8 port mode, and the memory expansion connectors 210 may be in the x8 port mode. Alternatively, the connectors at two ends of the first cable are in the x16 port mode, the first high-speed connector 410 may be in the x16 port mode, and the memory expansion connectors 210 may be in the x16 port mode. Alternatively, one connector at one end of the first cable is in the x16 port mode, and two connectors at the other end of the first cable are in the x8 port mode. For example, the first high-speed connector 410 may be in the x16 port mode, and the memory expansion connectors 210 may be in the x8 port mode. One first high-speed connector 410 in the x16 port mode is coupled to two memory expansion connectors 210 in the x8 port mode. Alternatively, the first high-speed connector 410 may be in the x8 port mode, and the memory expansion connectors 210 may be in the x16 port mode. Two first high-speed connectors 410 in the x8 port mode are coupled to one memory expansion connectors 210 in the x16 port mode.

This allows the server to choose an appropriate port mode from a plurality of modes to configure. the first high-speed connector 410 and the memory expansion connectors 210 based on actual conditions, enhancing the flexibility of server assembly.

In some embodiments, the expanded memory units in the expanded memory module group 400 may also include a memory expansion controller 430. The memory expansion controller 430 is serially connected between the first high-speed connector 410 and the memory medium 420. Understandably, the first high-speed connector 410 is coupled to the memory expansion controller 430 which in turn is coupled to the memory medium 420.

Since the memory controller expansion 430 is serially connected between the first high-speed connector 410 and the memory medium 420, the type of the memory medium 420 in the expanded memory module group 400 is not restricted by the CPU 300. Therefore, a plurality of memory media 420 coupled to a same memory expansion controller 430 can be of different types. In addition, the memory media coupled to different memory expansion controllers 430 may also be of different types.

When the expanded memory module group 400 does not include the memory expansion controller 430, a communication protocol needs to be unified within a communication network consisting of the CPU 300, the memory expansion connectors, the first high-speed connector, and the storage medium. This allows the CPU 300 and the memory medium in the expanded memory module group 400 to exchange signals and coordinate on operations. When the expanded memory module group 400 does not include the memory expansion controller 430, as shown in FIG. 6, the memory expansion controller 430 may convert a communication protocol. This allows the communication protocol between the memory medium and the memory expansion controller to be inconsistent with the communication protocol within the communication network consisting of the CPU 300, the memory expansion connectors, the first high-speed connector, and the memory expansion controller. The memory expansion controller 430 may convert a communication protocol of data provided by the memory medium 420 into a communication protocol capable of communicating with the CPU 300. Thus, the expanded memory module group 400 may include various types of memory media with different communication protocols. For example, the plurality of memory media in the expanded memory module group 400 may include DDR5 and SCM.

In some embodiments, in the expanded memory module group 400, a quantity of the first high-speed connectors 410 is equal to a quantity of the memory expansion controllers 430. For example, a plurality of first high-speed connectors 410 in the expanded memory module group 400 are coupled to a plurality of memory expansion controllers 430 in a one-to-one correspondence.

In some other embodiments, in the expanded memory module group 400, the quantity of the first high-speed connectors 410 is unequal to the quantity of the memory expansion controllers 430. For example, one memory expansion controller 430 in the expanded memory module group 400 is coupled to a plurality of first high-speed connectors 410 at the same time. Alternatively, one first high-speed connector 410 in the expanded memory module group 400 is coupled to a plurality of memory expansion controllers 430 at the same time.

In some embodiments, in the expanded memory module group 400, a quantity of the memory media 420 is greater than or equal to a quantity of the memory expansion controllers 430. For example, one memory expansion controller 430 is coupled to only one memory medium 420. Alternatively, one memory expansion controller 430 is coupled to a plurality of memory media 420, which further increases the quantity of memory of the expanded memory module group 400, enhancing the processing performance of the server.

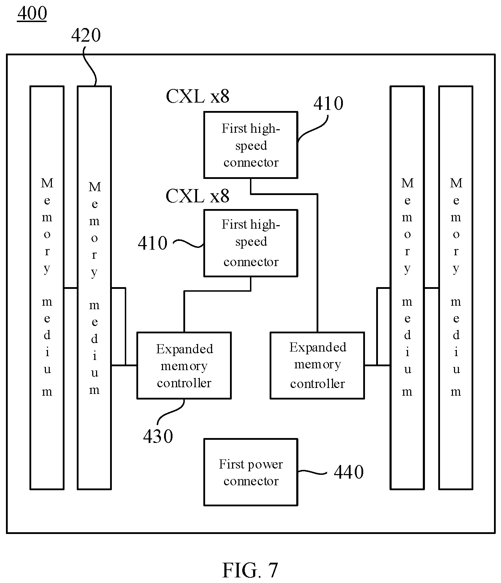

As shown in FIG. 3 and FIG. 7, in some embodiments, the expanded memory module group 400 in the server may include four expanded memory units, and each expanded memory unit may include two first high-speed connectors 410, two memory expansion controllers 430, and four memory media 420. Within the expanded memory unit, one first high-speed connector 410 is coupled to one memory expansion controller 430 which in turn is coupled to two memory media 420. Another first high-speed connector 410 is coupled to another memory expansion controller 430 which is coupled to two other memory media 420. Outside the expanded memory module group, the first high-speed connector 410 inside the expanded memory module group is coupled to the memory expansion connectors 210 on the mainboard 200 via the first cable in the flexible cable bundle 700.

As shown in FIG. 7, the expanded memory module group 400 may also include the first power connector 440. The mainboard 200 may include the second power connector (not shown in the figure). The flexible cable bundle 700 may also include a power cable, where the first power connector 440 is coupled to the second power connector by the power cable.

The power connectors can be at least one of the following types compliant with the PCIE CEM standard: 2 x 3-pin power connectors, 2 x 4-pin power connectors, or 2 x 6-pin power connectors. The first power connector and the second power connector may be of the same type. For example, the first power connector and the second power connector are 2 x 3-pin power connectors, or 2 x 4-pin power connectors. The first power connector and the second power connector may also be of different types. For example, the first power connector is a 2 x 6-pin power connector, and the second power connector is a 2 x 3-pin power connector. One 2 x 6-pin power connector is coupled to two 2 x 3-pin power connectors.

In this way, the server may choose appropriate power cables and power connectors from a plurality of power cables and ports based on actual conditions, enhancing the flexibility of server assembly.

In some embodiments, the flexible cable bundle 700 may also include the second cable that supports the System Management Bus (System Management Bus, SMBus). The server can also include a baseboard management controller (Baseboard Management Controller, BMC). The BMC is coupled to the first high-speed connector 410 in the expanded memory module group 400 by the second cable.

It should be noted that the BMC has different names for various computing devices. For example, some companies refer to the BMC as BMC, some as iLO (Integrated Ligths-out), and others as iDRAC (Integrated Dell Remote Access Controller). Regardless of whether the BMC is called BMC, iLO, or iDRAC, it can be understood as the BMC in the embodiment. The BMC, a second cable that supports the SMBus, and an out-of-band port of the first high-speed connector 410 constitute a dedicated management network that is independent of the data network (which includes a communication channel between the CPU 300 and the data port of the first high-speed connector 410). The dedicated network enables out-of-band management of the expanded memory module group 400, which includes, but is not limited to intelligent power distribution, load measurement, temperature monitoring, error detection, log querying, device management, and remote control.

For example, while the expanded memory module group 400 is running, the BMC can obtain running data of the expanded memory module group 400 from the first high-speed connector 410 by the second cable that supports the SMBus to monitor the expanded memory module group 400.

In some embodiments, as shown in FIG. 2, the server may also include a bracket 600. The bracket 600 may be fixed to the housing 100, located on one side of the mainboard 200, and the expanded memory module group 400 is installed on the bracket 600. Therefore, the expanded memory module group 400 is suspended above the mainboard 200.

The bracket 600 may be fixed to the bottom cover of the housing 100. For example, one end of the bracket 600 is screwed to the bottom cover, while the other end of the bracket 600 features a support on one side of the mainboard, spaced apart from the mainboard. The memory module group 400 is securely attached to the support.

The bracket 600 may also be fixed to two enclosure frames 110 that are oppositely arranged on the housing 100. For example, the bracket 600 may include two connection structures 610 and a suspension structure 620 between the two connection structures 610. The two connection structures 610 are respectively fixed to the two enclosure frames 110 oppositely arranged on the housing by screws, and the suspension structure 620 is fixed to the expanded memory module group 400.

In some examples, as shown in FIG. 2, the suspension structure 620 may be located on the side of the connection structures 610 that is closer to the mainboard 200. In this arrangement, a distance between the suspension structure 620 and the mainboard 200 is relatively small. The expanded memory module group 400 may be located on a side of the suspension structure 620 that is farther from the mainboard 200. Therefore, the suspension structure 620 is located between the mainboard 200 and the expanded memory module group 400. In this way, the bracket is fixed to the housing, allowing replacement and maintenance of the expanded memory module group 400 after the top cover is removed.

In some other examples, the suspension structure 620 may be flush with the edges of the enclosure frames 110 that is farther from the mainboard 200. In this arrangement, the distance between the suspension structure 620 and the mainboard 200 is relatively large. The expanded memory module group 400 may be located on the side of the suspension structure 620 that is closer to the mainboard 200. Therefore, the expanded memory module group 400 is located between the mainboard 200 and the suspension structure 620. This allows the replacement and maintenance of the expanded memory module group 400 after the bracket is removed from the housing.

In some embodiments, as shown in FIG. 3, the expanded memory module group 400 and the CPU 300 are located on the same side of the mainboard 200. An orthogonal projection of the expanded memory module group 400 on the mainboard 200 overlaps, at least partially, with an orthogonal projection of the CPU 300 on the mainboard 200. Understandably, the expanded memory module group 400 is located on a side of the CPU 300 that is farther from the mainboard 200, and covers at least part of the CPU 300.

In some examples, the orthogonal projection of the expanded memory module group 400 on the mainboard 200 overlaps with the orthogonal projection of the CPU 300 on the mainboard 200. Understandably, the expanded memory module group 400 fully covers the CPU 300. In some other examples, the orthogonal projection of the expanded memory module group 400 on the mainboard 200 partially overlaps with the orthogonal projection of the CPU 300 on the mainboard 200. Understandably, the expanded memory module group 400 partially covers the CPU 300.

When the orthogonal projection of the expanded memory module group 400 on the mainboard 200 at least partially overlaps with the orthogonal projection of the CPU 300 on the mainboard 200, the expanded memory module group 400 may be arranged close to the CPU 300. This in turn reduces a signal transmission distance during the signal interaction between the expanded memory module group 400 and the CPU 300, enhancing the completeness of transmitted signals. Meanwhile, there are no obstructions on the side of the CPU that is farther from the mainboard in the server. The expanded memory module group 400 covers at least part of the CPU 300, which facilitates to install the expanded memory module group 400.

In some embodiments, the expanded memory module group 400 and the memory module group 500 are on the same side of the mainboard 200, and the orthogonal projection of the expanded memory module group 400 on the mainboard 200 at least partially overlaps with an orthogonal projection of the memory module group 500 on the mainboard 200. Understandably, the expanded memory module group 400 is located on the side of the memory module group 500 that is farther from the mainboard 200, and covers at least part of the memory module group 500.

In some examples, the orthogonal projection of the expanded memory module group 400 on the mainboard 200 coincides with the orthogonal projection of the memory module group 500 on the mainboard 200. Understandably, the expanded memory module group 400 fully covers the memory module group 500. In some other examples, the orthogonal projection of the expanded memory module group 400 on the mainboard 200 partially overlaps with the orthogonal projection of the memory module group 500 on the mainboard 200. Understandably, the expanded memory module group 400 partially covers the memory module group 500.

When the orthogonal projection of the expanded memory module group 400 on the mainboard 200 at least partially overlaps with the orthogonal projection of the memory module group 500 on the mainboard 200, memory module groups that cooperate with the CPU 300 can be arranged closely, facilitating maintenance and replacement of all memory module groups within the server. Meanwhile, there are no obstructions on the side of the memory module group that is farther from the mainboard in the server. The expanded memory module group 400 covers at least part of the memory module group 500, which facilitates to install the expanded memory module group 400.

When the expanded memory module group 400, CPU 300, and memory module group 500 are all on the same side of the mainboard 200, there are four possible arrangements: 1. The orthogonal projection of the expanded memory module group 400 on the mainboard 200 may overlap with the orthogonal projections of the CPU 300 and of the memory module group 500 on the mainboard 200. 2. The orthogonal projection of the expanded memory module group 400 on the mainboard 200 may overlap with the orthogonal projection of the CPU 300 on the mainboard 200 and partially overlap with the orthogonal projection of the memory module group 500 on the mainboard 200. 3. The orthogonal projection of the expanded memory module group 400 on the mainboard 200 may partially overlap with the orthogonal projection of the CPU 300 on the mainboard 200 and overlap with the orthogonal projection of the memory module group 500 on the mainboard 200. 4. The orthogonal projection of the expanded memory module group 400 on the mainboard 200 may partially overlap with the orthogonal projections of the CPU 300 and of the memory module group 500 on the mainboard 200.

In some embodiments, as shown in FIG. 3, the memory expansion connectors 210 and the expanded memory module group 400 are on the same side of the mainboard 200, which shortens the lengths of the flexible cable bundle 700 connected to the memory expansion connectors 210 and the expanded memory module group 400, thereby reducing a distance of signal transmission between the CPU 300 and the expanded memory module group 400 and improving the completeness of transmitted signals.

In some embodiments, as shown in FIG. 3, the orthogonal projection of the memory expansion connectors 210 on the mainboard 200 does not overlap with the orthogonal projection of the expanded memory module group 400 on the mainboard 200. Understandably, the expanded memory module group 400 does not obstruct the memory expansion connectors 210 on the mainboard 200. Thus, after the expanded memory module group 400 is secured in place, the flexible cable bundle 700 and the memory expansion connectors 210 can be easily assembled.

In some other embodiments, the orthogonal projection of the memory expansion connectors 210 on the mainboard 200 may also overlap with the orthogonal projection of the expanded memory module group 400 on the mainboard 200, which is not limited herein.

In some examples, the plurality of memory expansion connectors 210 may be on the same side of the expanded memory module group 400. In other examples, as shown in FIG. 3, the plurality of memory expansion connectors 210 may also be on two sides of the expanded memory module group 400.

In some embodiments, as shown in FIG. 8, the server may also include an input/output (I/O) module 800. The I/O module 800 is coupled to the mainboard 200. The input/output module 800 may include a variety of ports, such as drive ports, NIC ports, Universal Serial Bus (Universal Serial Bus, USB) ports, PSU ports, High-Definition Multimedia Interface (High Definition Multimedia Interface, HDMI) ports, GPU ports, Video Graphics Array (Video Graphics Array, VGA) ports, and so on, which are not limited herein.

The plurality of ports on the I/O module 800 can be on one side of the mainboard 200, each coupled to an I/O controller chip or the CPU 300 on the mainboard 200, thus enabling signal interaction between external devices and a plurality of functional modules within the server.

Since the I/O module 800 has a large quantity of ports, a size of the I/O module 800 is larger than that of the CPU 300 in the direction perpendicular to the mainboard 200 in the server.

In some embodiments, as shown in FIG. 8, the server may also include a heat dissipation module 900, which is coupled to the mainboard 200 to obtain the operating voltage. The heat dissipation module 900 may dissipate heat inside the server by air cooling. Therefore, the heat dissipation module 900 may be a fan module. The fan module may include a plurality of fans which can be arranged closely or spaced apart. A plurality of adjacent fans may be arranged side by side or stacked, which is not limited herein.

As the fans are relatively large, a size of the heat dissipation module 900 is larger than that of the CPU 300 in the direction perpendicular to the mainboard 200 in the server.

Due to the large dimensions of the I/O module 800 and the heat dissipation module 900 in the direction perpendicular to the mainboard 200, positioning the expanded memory module group 400 away from the I/O module 800 and the heat dissipation module 900 can reduce the size of the server in the direction perpendicular to the mainboard 200, making the server smaller.

In some embodiments, as shown in FIG. 2 and FIG. 8, the I/O module 800 and the heat dissipation module 900 are at opposite ends of the mainboard 200. The expanded memory module group 400 is located between the I/O module 800 and the heat dissipation module 900. In some examples, the functional modules such as the CPU 300, the memory module group 500, may also be located between the I/O module 800 and the heat dissipation module 900.

In some examples, in the direction perpendicular to the mainboard 200, a height range of the I/O module 800 at least partially overlaps with a height range of the expanded memory module group 400. Understandably, the I/O module 800 and the expanded memory module group 400 overlap in height. This allows for optimization of the internal spatial layout of the server.

As shown in FIG. 9, in the direction perpendicular to the mainboard 200, the height range of the I/O module 800 is *d1*, the height range of the expanded memory module group 400 is *d2,* and an overlapped height range between *d1* and *d2* is *d3.* 0 < *d3* ≤ *d2.* The expanded memory module group 400 overlaps with the I/O module 800 in a height range of *d3* in the direction perpendicular to the mainboard 200, thus optimizing the spatial layout inside the server in the direction perpendicular to the mainboard 200.

In some examples, in the direction perpendicular to the mainboard 200, a height range of the heat dissipation module 900 at least partially overlaps with the height range of the expanded memory module group 400. Understandably, the heat dissipation module 900 and the expanded memory module group 400 overlap in height. This allows for optimization of the internal spatial layout of the server.

As shown in FIG. 9, in the direction perpendicular to the mainboard 200, the height range of the heat dissipation module 900 is *d4*, the height range of the expanded memory module group 400 is *d2,* and the overlapped height range between *d4* and *d2* is *d5.* 0 < *d5* ≤ *d2.* The expanded memory module group 400 overlaps with the heat dissipation module 900 in a height range of *d5* in the direction perpendicular to the mainboard 200, thus optimizing the spatial layout inside the server in the direction perpendicular to the mainboard 200.

In some other embodiments, when the server 1000 has a large dimension in the direction perpendicular to the mainboard 200, the height range of the I/O module 800 or the heat dissipation module 900 may not overlap with the height range of the expanded memory module group 400 in the direction perpendicular to the mainboard 200.

In summary, in the server in the embodiment, the expanded memory module group 400 is on one side of the mainboard 200 and spaced from the mainboard 200. This ensures that the expanded memory module group 400 is not limited to the space on the mainboard 200, enabling expansion of the quantity of memory that works with the CPU 300, thereby enhancing the operating capacity of the server.

The embodiment also provides an electronic device. The electronic device may include at least one server, at least one cabinet, at least one PSU, at least one network switch, and so on as described in some embodiments. The PSU is coupled to the server to provide power, and the network switch is coupled to the server to enable signal interaction between the server and other devices in the network.

Since the electronic device includes the server as described in some embodiments, the electronic device also has the advantages of the server, which is not described in details here.

The previously described are only the embodiments of the present application, but the protection scope of the present application is not limited to the embodiments. Any changes or substitutions within the technical scope disclosed in the present application shall fall within the protection scope of the present application. Therefore, the protection scope of the present application shall be subject to the protection scope of the claims.

## Claims

1. A server, **characterized by** comprising:
a mainboard, comprising memory expansion connectors;
a central processing unit (CPU) on the mainboard and coupled to the memory expansion connectors; and
an expanded memory module group, located on one side of the mainboard and spaced from the mainboard; wherein the expanded memory module group is coupled to the memory expansion connectors.

2. The server according to claim 1, wherein the expanded memory module group comprises a plurality of expanded memory units, the plurality of expanded memory units are independently arranged, and each expanded memory unit is coupled to one or more of the memory expansion connectors.

3. The server according to claim 2, wherein each expanded memory unit comprises a circuit board; and
a plurality of circuit boards of different expanded memory units are spaced apart from each other.

4. The server according to claim 2, wherein each expanded memory unit comprises a circuit board; and
a plurality of circuit boards of different expanded memory units are interconnected to form an integrated structure.

5. The server according to any one of claims 1 to 4, wherein the server comprises a first cable that supports a cache-coherent bus; and
the expanded memory unit, comprising:
a first high-speed connector coupled to the memory expansion connectors via the first cable; and
memory media coupled to the first high-speed connector.

6. The server according to claim 5, wherein the expanded memory unit further comprises:
a memory expansion controller serially coupled between the first high-speed connector and the memory media; and
a plurality of memory media coupled to one of the memory expansion controllers, comprising one or more types of memory media.

7. The server according to any one of claims 1 to 6, further comprising:
a housing, enclosing an accommodation cavity, wherein the mainboard is in the accommodation cavity; and
a bracket, connected to the housing; wherein the bracket is located on one side of the mainboard and is spaced apart from the mainboard; and the expanded memory module group is arranged on the bracket.

8. The server according to any one of claims 1 to 7, wherein the extended memory module group and the CPU are on a same side of the mainboard; and
an orthogonal projection of the expanded memory module group on the mainboard at least partially overlaps with an orthogonal projection of the CPU on the mainboard.

9. The server according to any one of claims 1 to 8, further comprising:
a memory module group located on the mainboard and spaced apart from the CPU; and
an orthogonal projection of the expanded memory module group on the mainboard at least partially overlaps with an orthogonal projection of the memory module group on the mainboard.

10. An electronic device, comprising a power supply unit (PSU) and a server, wherein the server is coupled to the PSU, and the server is the server according to any one of claims 1 to 9.
